# EUROPEAN PATENT APPLICATION

(11) **EP 4 773 784 A1**
(43) Date of publication of application: **08.07.2026**
(21) Application number: 24859532.4
(22) Date of filing: 20.08.2024
(51) Int. Cl.: H10N 30/05, H10N 30/853

(54) **PIEZOELECTRIC ELEMENT**

(30) Priority: 01.09.2023 JP 2023141986
(71) Applicant: Niterra Co., Ltd., Nagoya-shi, Aichi 461-0005 (JP)
(72) Inventor: IKEO Tomoaki, Nagoya-shi, Aichi 461-0005 (JP); KIMURA Takeshi, Nagoya-shi, Aichi 461-0005 (JP); TATSUDA Tetsuya, Nagoya-shi, Aichi 461-0005 (JP); SHIRATORI Tatsuya, Nagoya-shi, Aichi 461-0005 (JP); KASASHIMA Takashi, Nagoya-shi, Aichi 461-0005 (JP); MATSUSAKI Tatsuya, Nagoya-shi, Aichi 461-0005 (JP)
(74) Representative: Grünecker Patent- und Rechtsanwälte PartG mbB
(86) International application number: PCT/JP2024/029401
(87) International publication number: WO 2025/047499

(57) **Abstract**

A piezoelectric element 1 according to the present disclosure is a piezoelectric element 1 including multiple piezoelectric bodies 2, having piezoelectricity, and multiple electrodes stacked alternately. At least one of the piezoelectric bodies 2 has a slit 6 in its lateral surface. The outer periphery of a cross section of the portion of the piezoelectric element 1 having the slit 6 obtained by cutting in the direction perpendicular to the stacking direction has multiple sides 20 and multiple stress relaxation portions 30 each connecting an adjacent pair of the sides 20. The stress relaxation portions 30 are formed such that when each point at which extensions of an adjacent pair of the sides 20 intersect is defined as an imaginary vertex 22, the slit 6 is located closer to the center of the piezoelectric body 2 than the imaginary vertices 22.

## Description

### Technical Field

The present disclosure relates to a piezoelectric element.

### Background Art

In the related art, PZT (lead zirconate titanate) has been widely used as a ceramic material that exhibits piezoelectricity. A piezoelectric body made of PZT expands and contracts in response to applied voltage, and multilayer piezoelectric actuator elements, which have a structure in which multiple piezoelectric bodies and multiple inner electrodes are stacked alternately, have been developed and are in practical use. In a multilayer piezoelectric actuator element, the portion of each piezoelectric body sandwiched between inner electrodes becomes a polarized region, and the portion not sandwiched between the inner electrodes becomes a nonpolarized region. As a result, displacement distribution significantly changes at the boundary between the polarized region and the nonpolarized region, leading to stress concentration in this area. This stress concentration increases the likelihood of crack formation during prolonged operation, resulting in reduced durability.

To relax such stress, known multilayer piezoelectric actuator elements have slits created in the lateral surfaces of the multilayer body and in the direction perpendicular to the stacking direction (parallel to the surfaces of the stacked layers). For example, the multilayer piezoelectric actuator element described in Japanese Unexamined Patent Application Publication No. 2009-131138 (PTL 1 below) includes a pillar-shaped multilayer body in which multiple piezoelectric layers and multiple inner electrodes are alternately stacked. The multilayer body has multiple slits that are created in opposite lateral surfaces of the multilayer body such that they reach the interior of the piezoelectric layers and extend at certain intervals along the direction of stacking in the multilayer body. The multilayer body also has side electrodes formed on the opposite lateral surfaces of the multilayer body in such a manner that they are divided by the slits, with the side electrodes electrically coupled to the inner electrodes.

### Citation List

### Patent Literature

PTL 1: Japanese Unexamined Patent Application Publication No. 2009-131138

### Summary of Invention

### Technical Problem

Since PZT contains lead as a constituent, however, its environmental impact is a matter of concern. In recent years, therefore, the development of lead-free piezoelectric ceramic materials as an example of ceramic materials containing no lead has been ongoing. Lead-free piezoelectric ceramic materials, however, are less deformable and exhibit higher rigidity compared with PZT, which means that simply providing slits may result in insufficient stress relaxation. More specifically, this approach may fail to sufficiently relax the stress in the portions of the piezoelectric element having slits. Solution to Problem

A piezoelectric element according to the present disclosure is a piezoelectric element including multiple piezoelectric bodies, having piezoelectricity, and multiple electrodes stacked alternately, wherein at least one of the piezoelectric bodies has a slit in a lateral surface thereof; an outer periphery of a cross section of a portion of the piezoelectric element having the slit obtained by cutting in a direction perpendicular to a stacking direction has multiple sides and multiple stress relaxation portions each connecting an adjacent pair of the sides, and the stress relaxation portions are formed such that when each point at which extensions of an adjacent pair of the sides intersect is defined as an imaginary vertex, the slit is located closer to a center of the piezoelectric body than the imaginary vertices.

### Advantageous Effects of Invention

According to the present disclosure, stress in portions of a piezoelectric element having slits can be relaxed.

### Brief Description of Drawings

[Fig. 1] Fig. 1 is a sectional view schematically illustrating the structure of a piezoelectric element according to an embodiment.
[Fig. 2] Fig. 2 is a perspective view illustrating part of a multilayer body as separate components in the stacking direction.
[Fig. 3] Fig. 3 includes cross-sectional views illustrating a slit and its surrounding area in an enlarged view.
[Fig. 4] Fig. 4 is a diagram illustrating a cross section of a portion of a piezoelectric element having a slit, obtained by cutting in the direction perpendicular to the stacking direction.
[Fig. 5] Fig. 5 includes sectional views illustrating simulated stress behavior in a cross section that passes through a slit.
[Fig. 6] Fig. 6 is a graph illustrating the maximum stress acting on vertices versus R/(L1/2).
[Fig. 7] Fig. 7 is a graph illustrating the difference in stress between vertices and sides versus L1/L2.
[Fig. 8] Fig. 8 is a diagram illustrating a process flow for piezoelectric elements.
[Fig. 9] Fig. 9 includes sectional images of a slit. Description of Embodiments

### [Summary of Embodiments]

First, embodiments of the present disclosure will be listed and described.
(1) A piezoelectric element according to the present disclosure is a piezoelectric element including multiple piezoelectric bodies, having piezoelectricity, and multiple electrodes stacked alternately. At least one of the piezoelectric bodies has a slit in its lateral surface. The outer periphery of a cross section of the portion of the piezoelectric element having the slit obtained by cutting in the direction perpendicular to the stacking direction has multiple sides and multiple stress relaxation portions each connecting an adjacent pair of the sides. The stress relaxation portions are formed such that when each point at which extensions of an adjacent pair of the sides intersect is defined as an imaginary vertex, the slit is located closer to the center of the piezoelectric body than the imaginary vertices. The piezoelectric bodies may be ones formed of, for example, a lead-free piezoelectric ceramic composition.

The portion of each piezoelectric body sandwiched between an electrode and the electrode adjacent to it becomes a polarized region, and the portion not sandwiched between the two electrodes becomes a nonpolarized region. It is known that displacement distribution significantly changes at the boundary between the polarized region and the nonpolarized region, leading to stress concentration in this area. In particular, piezoelectric bodies formed of a lead-free piezoelectric ceramic composition are less deformable and exhibit higher rigidity compared with PZT. Thus, the inventors believe, simply creating slits may result in insufficient stress relaxation. To address this, the configuration described above is employed. With this configuration, stress relaxation can be achieved because multiple stress relaxation portions have been formed in addition to the creation of a slit.

(2) The stress relaxation portions are preferably formed as chamfers, which have a tapered shape.

Because the stress relaxation portions are formed as chamfers, the stress can be more easily dispersed throughout the chamfers.

(3) The stress relaxation portions are preferably formed as rounded corners, which have a curved shape.

Because the stress relaxation portions are formed as rounded corners, the stress can be more easily dispersed throughout the rounded corners.

(4) Preferably, when a line connecting adjacent two of the imaginary vertices is defined as an imaginary side, the length of the imaginary side is defined as L1, and the length of the region of the imaginary side over which a stress relaxation portion is formed is defined as R, R/(L1/2) is 15% or more and 100% or less.

With this configuration, the maximum stress that acts on the stress relaxation portions can be reduced.

(5) A piezoelectric element according to the present disclosure is a piezoelectric element including multiple piezoelectric bodies, having piezoelectricity, and multiple electrodes stacked alternately. At least one of the piezoelectric bodies has a slit in a lateral surface thereof. The outer periphery of a cross section of the portion of the piezoelectric element having the slit obtained by cutting in the direction perpendicular to the stacking direction is in a round shape or an oval shape. The piezoelectric bodies may be ones formed of, for example, a lead-free piezoelectric ceramic composition.

(6) Preferably, multiple slits are created at certain intervals in the stacking direction and every 35 or fewer layers.

### [Details of the Embodiments]

Specific examples of the present disclosure will be described below with reference to the drawings. It should be noted that the present disclosure is not limited to these illustrations but is intended to be defined by the claims and to include equivalents to the claims and all modifications within the scope of the claims.

### <Embodiments>

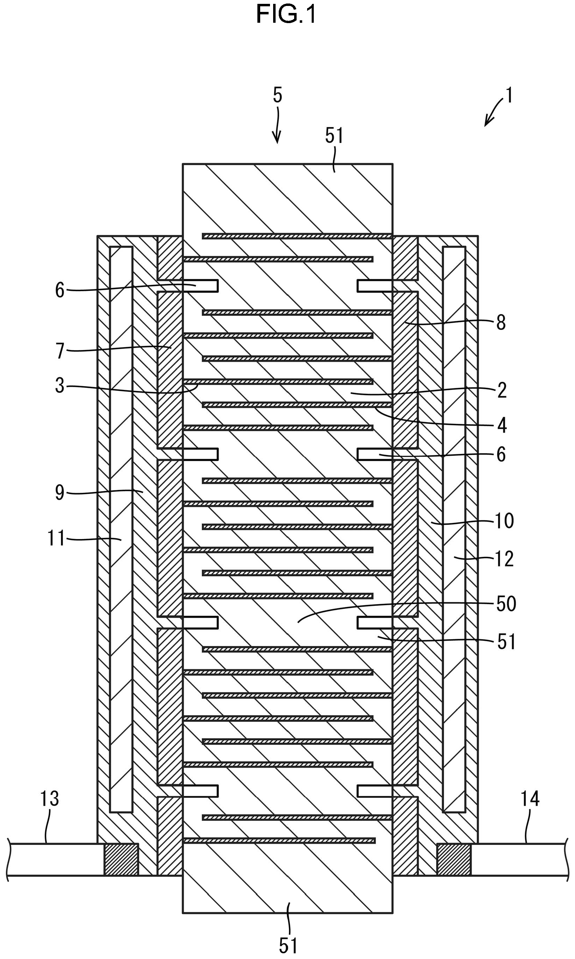

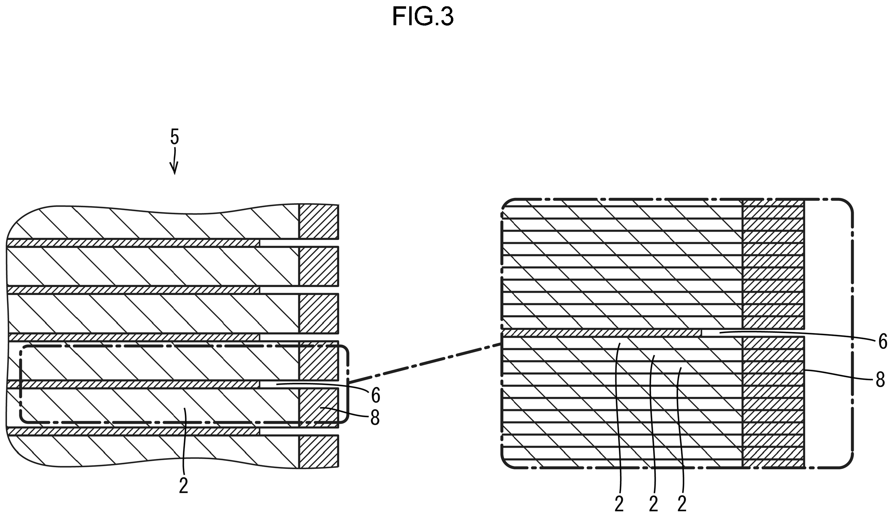

Embodiments of the present disclosure will be described using Fig. 1 to Fig. 9. As illustrated in Fig. 1, a piezoelectric element 1 includes a multilayer body 5 composed of multiple piezoelectric bodies 2 formed of a lead-free piezoelectric ceramic composition, having piezoelectricity, and multiple inner electrodes 3 and 4, having electrical conductivity, stacked alternately. It should be noted that in Fig. 1, the number of layers stacked in the multilayer body 5 is illustrated smaller than in reality due to omission. In an actual piezoelectric element 1, however, the number of layers stacked is large, for example as illustrated in Fig. 3.

### [Piezoelectric Bodies 2]

The piezoelectric bodies 2 are layers of a lead-free piezoelectric ceramic composition having a primary phase formed by a first crystal phase made of an alkali-niobate perovskite oxide and secondary phases including a second crystal phase made of an M-Ti-O spinel compound.

As used herein, "spinel compounds" include both normal spinel compounds, which have a normal spinel crystal structure, and inverse spinel compounds, which have an inverse spinel crystal structure. Element M in the M-Ti-O spinel compound is at least one monovalent to tetravalent metal element.

The percentage of the second crystal phase in the lead-free piezoelectric ceramic composition, furthermore, is more than 0% by volume and 10% by volume or less, with the remainder being the first crystal phase. Herein, the first crystal phase is also referred to as "the primary phase," and crystal phases other than the primary phase are referred to as "secondary phases."

The alkali-niobate perovskite oxide in the first crystal phase is represented by composition formula (1) below.

(KaNabLicCd)e(DfEg)Oh ..... (1)

It should be noted that element C is at least one or more of Ca (calcium) and Ba (barium), element D is one or more of Nb (niobium), Ti (titanium), and Zr (zirconium) including at least Nb, and element E is at least one or more of Fe (iron), Co (cobalt), Zn (zinc), and Mg (magnesium).

In composition formula (1) above, K (potassium), Na (sodium), Li (lithium), and element C are positioned in the so-called A-site in the perovskite structure. Element D and element E, furthermore, are positioned in the so-called B-site in the perovskite structure.

As for the values of coefficients a, b, c, d, e, f, g, and h in composition formula (1) above, values that allow for the formation of a perovskite structure and are preferred from the viewpoint of the electrical characteristics or piezoelectric characteristics (in particular, the piezoelectric constant d33) of the lead-free piezoelectric ceramic composition are selected. At the same time, values that are preferred from the viewpoint of maintaining a low sintering temperature during manufacturing are selected.

Specifically, the total of coefficients a, b, c, and d, for the A-site elements, is 1 (in other words, a + b + c + d = 1).

For coefficients a, b, and c, it is preferred that 0 ≤ a < 1, 0 ≤ b < 1, and 0 ≤ c < 1, respectively. It is, however, preferred that the following do not hold true: a = b = c = 0 (i.e., a lead-free piezoelectric ceramic composition containing none of K, Na, and Li). For coefficients a and b, for K and Na, typically 0 < a ≤ 0.6, and 0 < b ≤ 0.6. Coefficient c, for Li, may be 0 (zero), but preferably 0 < c ≤ 0.2, more preferably 0 < c ≤ 0.1.

Coefficient d, for element C, may be 0 (zero), but preferably 0 < d ≤ 0.2, more preferably 0 < d ≤ 0.1.

Coefficient e, for the entire A-site, can be any value unless the objective of the present disclosure is defeated. It should be noted that for coefficient e, it is preferred that 0.80 ≤ e ≤ 1.10, more preferably 0.84 ≤ e ≤ 1.08, even more preferably 0.88 ≤ e ≤ 1.07.

The total of coefficients f and g, for B-site elements D and E, is 1 (in other words, f + g = 1). It should be noted that coefficient f, for element D, is preferably not 0 (zero), and coefficient g, for element E, may be 0 (zero), unless the objective of the present disclosure is defeated.

Coefficient h, for oxygen (O), can be any value that allows the first crystal phase to maintain a perovskite crystal structure. A typical value for coefficient h is approximately 3, and it is preferred that 3.0 ≤ h ≤ 3.1. It should be noted that the value of coefficient h can be calculated from electrical neutrality conditions for the composition of the first crystal phase. As the composition of the first crystal phase, however, a composition that slightly deviates from electrical neutrality conditions is also acceptable.

An alkali-niobate perovskite oxide represented by composition formula (1) above is referred to as "KNN" or a "KNN material" because it is an oxide containing K, Na, and Nb as its major metal components. Such an alkali-niobate perovskite oxide is superior in, for example, piezoelectric characteristics and electrical characteristics.

The M-Ti-O spinel compound in the second crystal phase is an oxide containing element M (at least one monovalent to tetravalent metal element) and Ti (titanium). It is represented by, for example, composition formula (2) below.

MxTiOy ..... (2)

In this formula, element M is at least one monovalent to tetravalent metal element. Specifically, element M consists of at least one or more selected from the group consisting of Li, Fe, Co, Zn, Zr, and Mg.

Coefficients x and y are relative values when the amount of Ti is defined as 1. For the second crystal phase to form a spinel compound, it is preferred that coefficient x satisfy 0.5 ≤ x ≤ 5.0. Coefficient y, furthermore, can be any value with which a spinel compound is formed, but for example, it is preferred that it satisfy 2 ≤ y ≤ 8.

The second crystal phase, composed of a spinel compound, stabilizes the structure of the first crystal phase. By virtue of this, a lead-free piezoelectric ceramic composition superior in piezoelectric characteristics can be obtained. It should be noted that it is preferred, for example from the viewpoint of piezoelectric characteristics, to employ a second crystal phase represented by the composition formula M₂TiO₄ or (M1,M2)TiO₄ containing two divalent metal elements M.

The second crystal phase does not have piezoelectric characteristics. By intermingling with the first crystal phase, however, it improves the sinterability of the lead-free piezoelectric ceramic composition, thereby improving its structural stability and improving its piezoelectric characteristics as well. Specifically, the second crystal phase fills voids created between crystals in the first crystal phase. As a result, presumably, the crystals in the first crystal phase are bound together by the second crystal phase, leading to improved structural stability and improved piezoelectric characteristics of the lead-free piezoelectric ceramic composition.

### [Inner Electrodes 3 and 4]

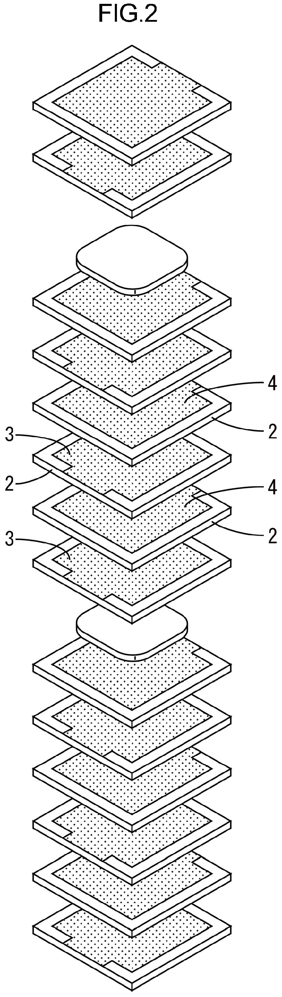

The inner electrodes 3 and 4 are, as illustrated in Fig. 2, arranged alternately with respect to the stacking direction, and one piezoelectric body 2 is sandwiched between an inner electrode 3 and an inner electrode 4. The inner electrodes 3 are configured as one set of electrodes with the same polarity (e.g., positive electrodes), and the inner electrodes 4 are configured as the other set of electrodes with the same polarity (e.g., negative electrodes). Inner electrodes 3 and 4 with different polarity are arranged spaced apart in the stacking direction not to electrically short-circuit.

One side edge (the edge on the left side in Fig. 1) of the inner electrodes 3 is formed to be exposed on a first lateral surface (the lateral surface on the left side in Fig. 1) of the multilayer body 5. The other side edge (the edge on the right side in Fig. 1) of the inner electrodes 3 is formed not to be exposed on a second lateral surface (the lateral surface on the right side in Fig. 1) of the multilayer body 5.

One side edge (the edge on the right side in Fig. 1) of the inner electrodes 4 is formed to be exposed on the second lateral surface (the lateral surface on the right side in Fig. 1) of the multilayer body 5. The other side edge (the edge on the left side in Fig. 1) of the inner electrodes 4 is formed not to be exposed on the first lateral surface (the lateral surface on the left side in Fig. 1) of the multilayer body 5.

By configuring the inner electrodes 3 and 4 in such a manner, electrical short-circuiting between inner electrodes 3 and 4 with different polarity is prevented.

### [Slits 6]

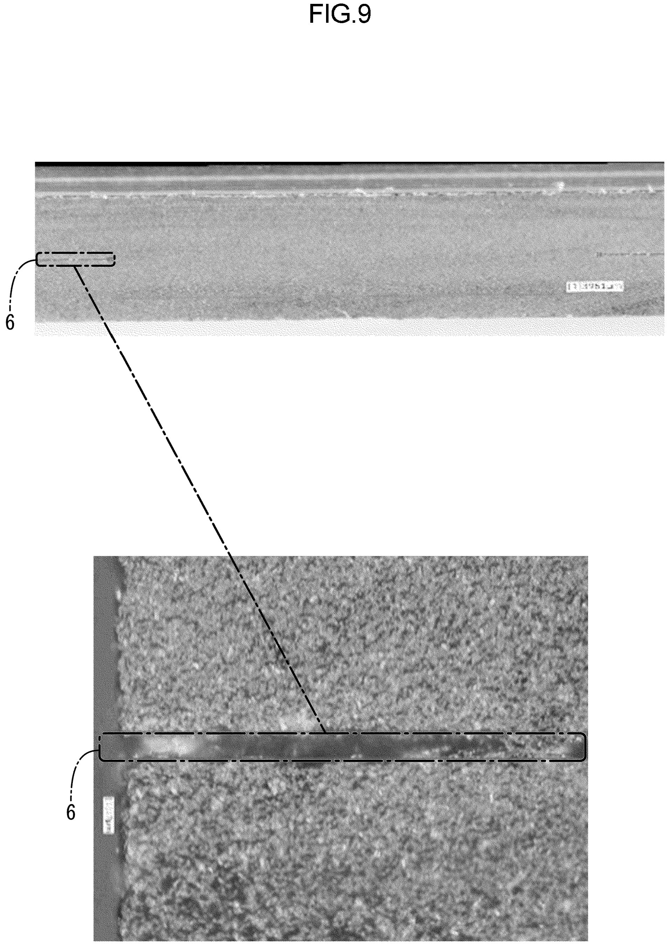

The outer lateral surfaces of the multilayer body 5 have slits 6 created in the direction perpendicular to the stacking direction (parallel to the surfaces of the stacked layers) around the entire body to reach a predetermined depth from the outer lateral surfaces. As illustrated in Fig. 1, the depth of the slits 6 from the outer lateral surfaces of the multilayer body 5 is set to be deeper than the end portions of the inner electrodes 3 and 4. Fig. 9 presents actual sectional images of a slit 6. Multiple slits 6 are created at certain intervals in the stacking direction and every 35 or fewer layers. These slits 6 are ones created for the purpose of relaxing the stress that applies when the piezoelectric element 1 is operated.

### [Side Electrodes 7 and 8]

On two opposite lateral surfaces of the multilayer body 5, furthermore, side electrodes 7 and 8 are formed. These side electrodes 7 and 8 have been formed by patterning a conductive paste, for example by screen printing, and are in a state in which they are separated in blocks divided in the stacking direction by the slits 6.

### [Outer Electrodes 11 and 12]

On the surface of the side electrodes 7 and 8 described above, solder layers 9 and 10 are formed. To the side electrodes 7 and 8, a pair of outer electrodes 11 and 12 are fastened with these solder layers 9 and 10 interposed therebetween. By virtue of this, the individual blocks of the side electrodes 7 and 8, divided in the stacking direction by the slits 6, are in a state of electrical continuity with each other. The outer electrodes 11 and 12 are formed of a conductive material (e.g., copper). The outer electrodes 11 and 12 are formed, for example, in a mesh shape, allowing them to deform in response to the expansion and contraction of the multilayer body 5.

### [Lead Electrodes 13 and 14]

In addition, to the lowest block of the side electrodes 7 and 8 in Fig. 1, of the blocks of the side electrodes 7 and 8 described above, lead electrodes 13 and 14 as voltage supply elements for supplying voltage from the outside are fastened with the solder layers 9 and 10 interposed therebetween. Since the lead electrodes 13 and 14 are fastened to the side electrodes 7 and 8, the outer electrodes 11 and 12 do not break, for example due to the inertial weight of the lead electrodes 13 and 14, even when the multilayer body 5 is vibrated for an extended period at a high speed.

The multilayer body 5 is composed of multiple piezoelectric bodies 2 and multiple inner electrodes 3 and 4 stacked alternately and includes polarized regions 50, which are displaced upon voltage application to the inner electrodes 3 and 4, and nonpolarized regions 51, which are not displaced. The nonpolarized regions 51 are positioned below, above, and around the polarized regions 50.

For the multilayer body 5, its lower side in Fig. 1 is configured as a fixed end, which is immobilized and not displaced, and its upper side is configured as a movable end, which is displaced. The lead electrodes 13 and 14 are fastened to the block of the side electrodes 7 and 8 located at the end portion closer to the fixed end. That is, the lead electrodes 13 and 14 are fastened to side electrodes 7 and 8 closer to the fixed end than the slit 6 closest to the fixed end.

### [Stress Relaxation Portions 30]

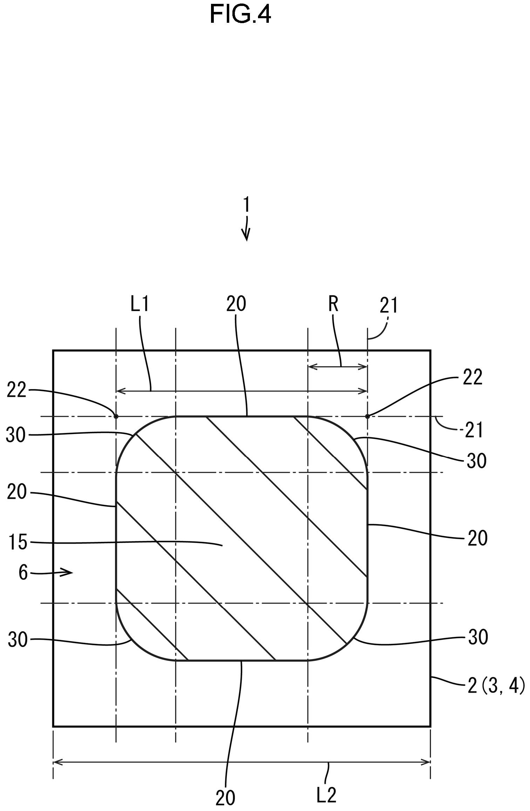

Fig. 4 is a cross section of a portion of the multilayer body 5 having a slit 6, obtained by cutting in the direction perpendicular to the stacking direction. The portion indicated by hatching in the middle of Fig. 4 is a piezoelectric body 2 connecting the piezoelectric body 2 above the slit 6 and the piezoelectric body 2 below the slit 6. Hereinafter, it is referred to as the connecting portion 15.

The outer periphery of a cross section of the connecting portion 15 has four sides 20 and four stress relaxation portions 30 each connecting an adjacent pair of the sides 20. The stress relaxation portions 30 are formed such that when each point at which extensions 21 of an adjacent pair of the sides 20 intersect is defined as an imaginary vertex 22, the slit 6 is located closer to the center of the piezoelectric body 2 than the imaginary vertices 22. Although the cross section of the connecting portion 15 in this embodiment is in a substantially square shape, it may be in a substantially triangular shape or may be in a substantially polygonal shape with five or more sides.

Although the stress relaxation portions 30 in an embodiment are formed as rounded corners, which have a curved shape, they may be formed as chamfers, which have a tapered shape. Although the outer periphery of the connecting portion 15 in an embodiment is formed by sides 20 in a straight-line shape and stress relaxation portions 30 in a round shape (quadrantal shape), furthermore, stress relaxation portions in an oval shape may be used instead of stress relaxation portions 30 in a round shape.

### [EXAMPLES]

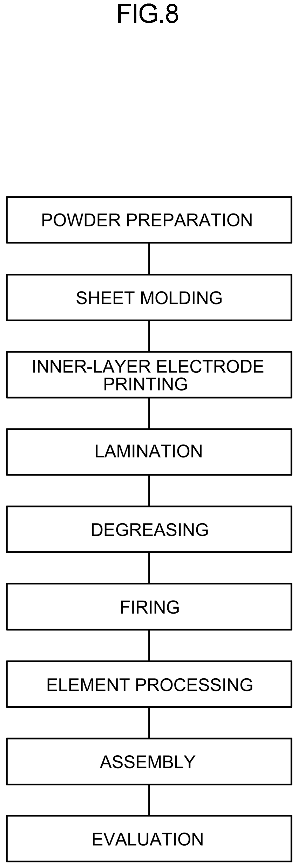

A process flow for piezoelectric elements 1 is presented in Fig. 8. First, multiple types of raw material powders required to form the primary phase were prepared, and these raw material powders were weighed out according to the values of coefficients a, b, c, d, e, f, and g in the composition formula for the primary phase to achieve the intended composition. The weighed raw material powders were milled and mixed for 4 hours or longer using a dry vibration mill, yielding a mixed powder. The resulting mixed powder was calcined for 1 to 10 hours, for example under temperature conditions of 600°C to 1200°C in an air atmosphere. Through this, a primary-phase calcined substance in powder form was obtained.

Multiple types of raw material powders required to form secondary phases, furthermore, were prepared, and these raw material powders were weighed out according to the value of coefficient x in the composition formula for the secondary phases to achieve the intended composition. The weighed raw material powders were milled and mixed for 4 hours or longer using a dry vibration mill, yielding a mixed powder. The resulting mixed powder was calcined for 1 to 10 hours, for example under temperature conditions of 600°C to 1200°C in an air atmosphere. Through this, a secondary-phase calcined substance in powder form was obtained (powder preparation).

Then a dispersant, a binder, and an organic solvent (e.g., toluene) were added to the resulting primary-phase calcined substance and secondary-phase calcined substance, and their wet mixture was milled and mixed to give a slurry. Thereafter, casting sheet molding was performed to process the slurry into a sheet form, through which ceramic green sheets having a predetermined thickness (hereinafter simply referred to as "green sheets") were produced (sheet molding).

Then a rectangle of 150 mm in the vertical direction × 150 mm in the horizontal direction was punched out of each green sheet, and an electrode layer to serve as an inner electrode was formed on one side of the green sheets using a conductive paste for inner electrodes (Pt paste), for example by screen printing (inner electrode printing).

Thereafter, a predetermined number of green sheets with no printed electrode layer (non-driven layers) and a predetermined number of green sheets with a printed electrode layer (driven layers) were stacked in order and laminated by applying temperature and pressure, and then the resulting structure was cut into small-piece elements. For example, lamination was performed with the temperature conditions being 40°C to 80°C and the pressure conditions being 5 to 100 MPa.

Debinding treatment was performed by, for example, maintaining the elements cut into small pieces under temperature conditions of 500°C to 800°C in an air atmosphere for 2 to 100 hours (degreasing).

The elements after the debinding treatment were fired by, for example, maintaining them under temperature conditions of 900°C to 1400°C in an air atmosphere for 1 to 100 hours (firing).

Then the four corners of the fired elements were cut to predetermined dimensions (e.g., a rectangle of 6 mm in the vertical direction × 6 mm in the horizontal direction) by dicing to expose the inner electrodes. The upper and lower surfaces of the elements were polished for thickness adjustment and, at the same time, processed to achieve a predetermined degree of parallelism. The elements, now in a rectangular parallelopiped shape, were subjected to slitting in the direction perpendicular to the stacking direction using a laser (manufactured by COHERENT; UV, GREEN, and IR wavelengths). The slits were created such that the radius of curvature of the stress relaxation portions was from 0 mm to 0.2 mm and the length of each side was from 1 mm to 5.4 mm (element processing).

Thereafter, electrodes were printed on lateral surfaces of the multilayer bodies and baked under temperature conditions of 600°C to 800°C, and polarization treatment was performed. Four of the resulting elements were assembled using an adhesive, the side electrodes of each element were connected via lead wires using solder, and the resulting structure was enclosed in a metal cylinder (assembly).

The evaluation step will now be described. For the simulation, analysis was performed using ANSYS Workbench 2021R2.

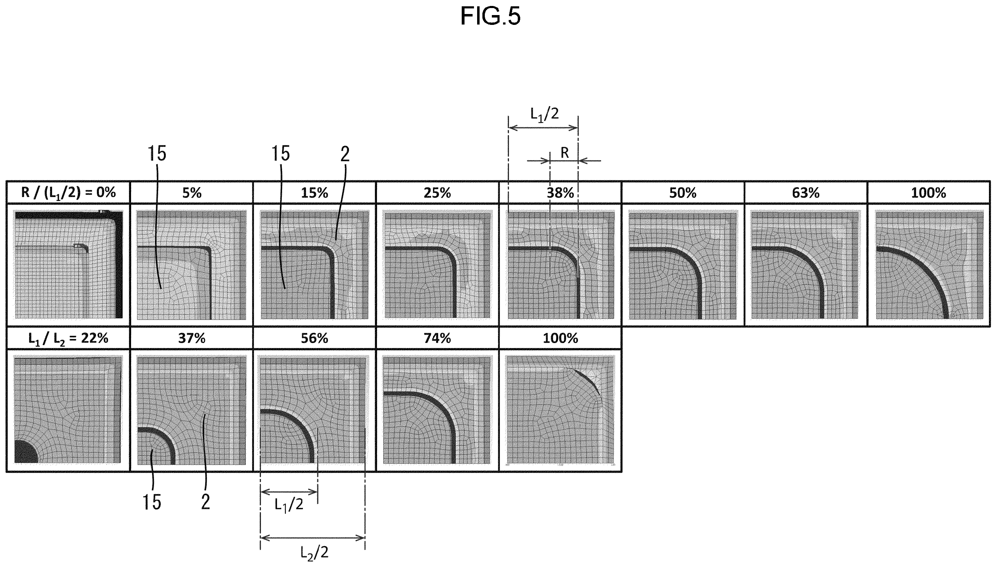

As illustrated in Fig. 4, a line connecting adjacent imaginary vertices 22 is defined as an imaginary side, the length of the imaginary side is defined as L1, and the length of the region of the imaginary side over which a stress relaxation portion 30 is formed is defined as R. The upper row of Fig. 5 includes sectional views illustrating simulated maximum stress that acts on the vertices of the connecting portion 15 (stress relaxation portions) when R/(L1/2) is varied within the range from 0% to 100%. Stressed areas are displayed in darker colors.

As illustrated in the upper row of Fig. 5, it can be seen that at 0% and 5%, the stress acts solely on the connecting portion 15. At 15% to 100%, by contrast, the stress acts on both the connecting portion 15 and the piezoelectric bodies 2 located directly above and below the connecting portion 15. In other words, at 15% to 100%, the stress is widely dispersed across the connecting portion 15 and the piezoelectric bodies 2. The stress acting on the connecting portion 15, therefore, is relaxed, leading to a smaller maximum stress.

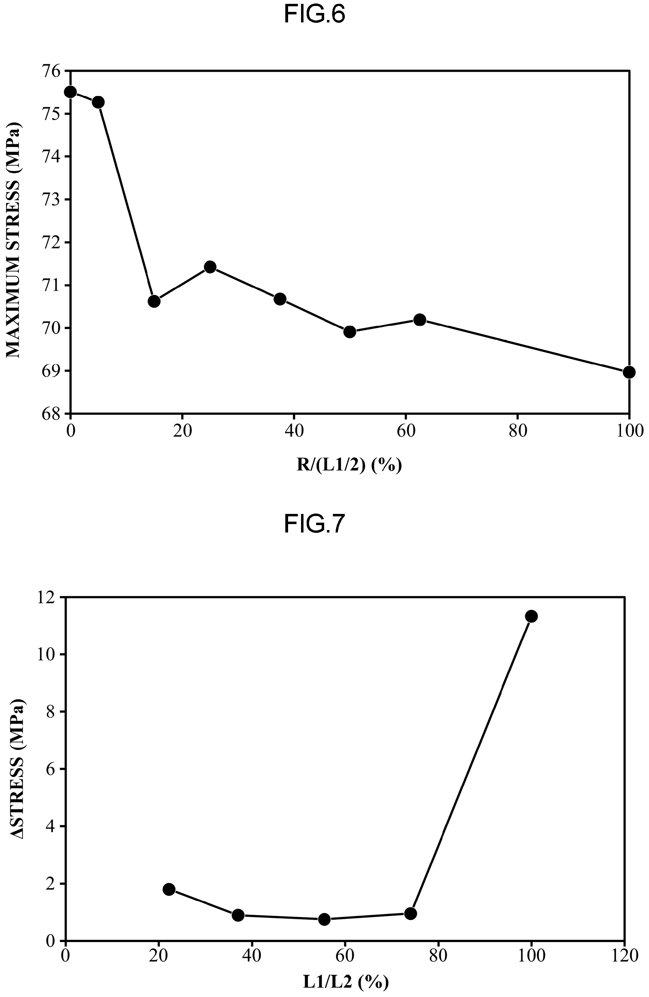

As illustrated in Fig. 6, it can be seen that when R/(L1/2) was 0% or 5% (when there was substantially no R in the stress relaxation portions 30), the maximum stress was greater than 75 MPa. When R/(L1/2) was 100% (when a sufficiently large R was given to the stress relaxation portions 30), by contrast, the maximum stress decreased to 69 MPa. The maximum stress in relation to R/(L1/2) is preferably 15% or more and 100% or less, more preferably 25% or more and 100% or less, even more preferably 38% or more and 100% or less, the most preferably 100%.

As illustrated in Fig. 4, the length of each side of the piezoelectric bodies 2 located directly above and below the connecting portion 15 (the length of each side of the inner electrodes 3 and 4) is defined as L2. The lower row of Fig. 5 includes sectional views illustrating simulated differences between the stress that acts on the vertices of the connecting portion 15 (stress relaxation portions) and the stress that acts on the sides when L1/L2 is varied within the range from 22% to 100%. At 100%, the stress is concentrated in the connecting portion 15. At 22% to 74%, however, the stress is widely dispersed along the outer periphery of the connecting portion 15. The stress acting on the connecting portion 15, therefore, is relaxed, leading to a smaller difference in stress.

As illustrated in Fig. 7, it can be seen that when L1/L2 was 100%, the difference in stress was 11 MPa. When L1/L2 was from 22% to 74%, by contrast, the difference in stress decreased to less than 2 MPa. The difference in stress in relation to L1/L2 is preferably 22% or more and 74% or less, more preferably 37% or more and 74% or less, the most preferably 56%.

### [Advantages of the Embodiments]

The piezoelectric element 1 is a piezoelectric element 1 including multiple piezoelectric bodies 2 formed of a lead-free piezoelectric ceramic composition, having piezoelectricity, and multiple inner electrodes 3 and 4 stacked alternately. At least one of the piezoelectric bodies 2 has a slit 6 in its lateral surface. The outer periphery of a cross section of the portion of the piezoelectric element 1 having the slit 6 obtained by cutting in the direction perpendicular to the stacking direction has four sides 20 and four stress relaxation portions 30 each connecting an adjacent pair of the sides 20. The stress relaxation portions 30 are formed such that when each point at which extensions 21 of an adjacent pair of the sides 20 intersect is defined as an imaginary vertex 22, the slit 6 is located closer to the center of the piezoelectric body 2 than the imaginary vertices 22.

The portion of each piezoelectric body 2 sandwiched between an inner electrode 3 and the inner electrode 4 adjacent to it becomes a polarized region 50, and the portion not sandwiched between the two electrodes 3 and 4 becomes a peripheral nonpolarized region 51. It is known that the displacement distribution significantly changes at the boundary between the polarized region 50 and the peripheral nonpolarized region 51, leading to stress concentration in this area. In particular, piezoelectric bodies 2 formed of a lead-free piezoelectric ceramic composition are less deformable and exhibit higher rigidity compared with PZT. Thus, the inventors believe, simply creating slits 6 may result in insufficient stress relaxation. To address this, the configuration described above is employed. With this configuration, stress relaxation can be achieved because multiple stress relaxation portions 30 have been formed in addition to the creation of a slit 6.

Because the stress relaxation portions 30 are formed as rounded corners, which have a curved shape, the stress can be more easily dispersed throughout the rounded corners.

When a line connecting adjacent two of the imaginary vertices 22 is defined as an imaginary side, the length of the imaginary side is defined as L1, and the length of the region of the imaginary side over which a stress relaxation portion 30 is formed is defined as R, R/(L1/2) is 15% or more and 100% or less. With this arrangement, the maximum stress that acts on the stress relaxation portions 30 can be reduced.

### Reference Signs List

1: piezoelectric element 2: piezoelectric body 3: inner electrode 4: inner electrode 5: multilayer body 6: slit 7: side electrode 8: side electrode 9: solder layer 10: solder layer 11: outer electrode 12: outer electrode 13: lead electrode 14: lead electrode 15: connecting portion
20: side 21: extensions of an adjacent pair of sides 22: imaginary vertex
30: stress relaxation portion
50: polarized region 51: nonpolarized region

## Claims

1. A piezoelectric element comprising a plurality of piezoelectric bodies, having piezoelectricity, and a plurality of electrodes stacked alternately, wherein:
at least one of the piezoelectric bodies has a slit in a lateral surface thereof;
an outer periphery of a cross section of a portion of the piezoelectric element having the slit obtained by cutting in a direction perpendicular to a stacking direction has a plurality of sides and a plurality of stress relaxation portions each connecting an adjacent pair of the sides; and
the stress relaxation portions are formed such that when each point at which extensions of an adjacent pair of the sides intersect is defined as an imaginary vertex, the slit is located closer to a center of the piezoelectric body than the imaginary vertices.

2. The piezoelectric element according to Claim 1, wherein the piezoelectric bodies are formed of a lead-free piezoelectric ceramic composition.

3. The piezoelectric element according to Claim 1, wherein the stress relaxation portions are formed as chamfers, which have a tapered shape.

4. The piezoelectric element according to Claim 1, wherein the stress relaxation portions are formed as rounded corners, which have a curved shape.

5. The piezoelectric element according to any one of Claim 1 to Claim 4, wherein:
when a line connecting adjacent two of the imaginary vertices is defined as an imaginary side, a length of the imaginary side is defined as L1, and a length of a region of the imaginary side over which a stress relaxation portion is formed is defined as R,
R/(L1/2) is 15% or more and 100% or less.

6. A piezoelectric element comprising a plurality of piezoelectric bodies, having piezoelectricity, and a plurality of electrodes stacked alternately, wherein:
at least one of the piezoelectric bodies has a slit in a lateral surface thereof; and
an outer periphery of a cross section of a portion of the piezoelectric element having the slit obtained by cutting in a direction perpendicular to a stacking direction is in a round shape or an oval shape.

7. The piezoelectric element according to Claim 6, wherein the piezoelectric bodies are formed of a lead-free piezoelectric ceramic composition.

8. The piezoelectric element according to Claim 1 or Claim 6, wherein a plurality of the slits are created at certain intervals in the stacking direction and every 35 or fewer layers.
